# EUROPEAN PATENT APPLICATION

(11) **EP 4 219 263 A1**
(43) Date of publication of application: **02.08.2023**
(21) Application number: 21885704.3
(22) Date of filing: 07.09.2021
(51) Int. Cl.: B61B 13/00, G05D 1/02

(54) **TRAVELING VEHICLE SYSTEM AND METHOD FOR CONTROLLING TRAVELING VEHICLE**

(30) Priority: 26.10.2020 JP 2020178816
(71) Applicant: Murata Machinery, Ltd., Kyoto-shi, Kyoto 601-8326 (JP)
(72) Inventor: HARASAKI, Kazumi, Inuyama-shi, Aichi 484-8502 (JP)
(74) Representative: Jordan, Volker Otto Wilhelm
(86) International application number: PCT/JP2021/032823
(87) International publication number: WO 2022/091585

(57) **Abstract**

A traveling vehicle system 1 includes a travel path 11, a plurality of traveling vehicles 5, and a traveling vehicle controller 3 configured to cause the traveling vehicles 5 to travel based on a travel route R11 searched for based on a conveyance command. The traveling vehicle controller 3 includes: an alternative target searching unit 43 configured to search, at a timing when the travel route R11 of a first traveling vehicle 5A as the traveling vehicle 5 allocated with the conveyance command has been changed, a second traveling vehicle 5B out of the traveling vehicles 5 not conveying an article as the traveling vehicle 5 capable of arriving at a destination included in the conveyance command in a shorter time than the first traveling vehicle 5A does; and an alternative controller 44 configured to reallocate the conveyance command from the first traveling vehicle 5A to the second traveling vehicle 5B when the second traveling vehicle 5B has been identified by the alternative target searching unit 43.

## Description

### Technical Field

An aspect of the present invention relates to a traveling vehicle system and a method for controlling a traveling vehicle causing traveling vehicles to travel on a preset travel path.

### Background Art

A traveling vehicle system is known including a plurality of traveling vehicles traveling along a travel path and a controller allocating conveyance commands to the traveling vehicles. The controller identifies a vacant traveling vehicle that can efficiently execute conveyance of an article and allocates a conveyance command to the identified traveling vehicle. If, after the conveyance command is allocated to the vacant traveling vehicle, a more appropriate vacant vehicle occurs as the traveling vehicle to be allocated with the conveyance command before arriving at a destination, the controller reallocates the conveyance command to that vacant traveling vehicle (alternative control). The controller determines whether to execute the alternative control at a timing when a vacant traveling vehicle has occurred.

### Citation List

### Patent Literature

[Patent Document 1] Japanese Unexamined Patent Publication No. 2010-066966

### Summary of Invention

### Technical Problem

The travel path in the traveling vehicle system may be provided with a branching part branching the travel direction of the traveling vehicle. The traveling vehicle may change in its route (distance) to the destination included in the conveyance command depending on the direction in which it travels at the branching part. When traveling through the branching part, if the route to the destination becomes longer, conveyance efficiency in the traveling vehicle reduces.

Thus, an object of an aspect of the present invention is to provide a traveling vehicle system and a method for controlling a traveling vehicle that can improve conveyance efficiency in a traveling vehicle.

### Solution to Problem

A traveling vehicle system according an aspect of the present invention is a traveling vehicle system including a travel path including a branching part and on which a traveling vehicle travels in one direction, a plurality of traveling vehicles configured to travel along the travel path and to deliver an article to and from a placement part provided along the travel path, and a traveling vehicle controller configured to cause the traveling vehicles to travel based on a travel route searched for based on a conveyance command for conveying the article, in which the traveling vehicle controller includes: an alternative target searching unit configured to search, at a timing when the travel route of a first traveling vehicle as the traveling vehicle allocated with the conveyance command has been changed, a second traveling vehicle out of the traveling vehicles not conveying an article as the traveling vehicle capable of arriving at a destination included in the conveyance command in a shorter time than the first traveling vehicle does; and an alternative controller configured to reallocate the conveyance command from the first traveling vehicle to the second traveling vehicle when the second traveling vehicle has been identified by the alternative target searching unit.

A method for controlling a traveling vehicle according an aspect of the present invention is a method for controlling a traveling vehicle in a traveling vehicle system including a travel path including a branching part and on which a traveling vehicle travels in one direction, a plurality of traveling vehicles configured to travel along the travel path and to deliver an article to and from a placement part provided along the travel path, and a traveling vehicle controller configured to cause the traveling vehicles to travel based on a travel route searched for based on a conveyance command for conveying the article, the method including: identifying, at a timing when the travel route of a first traveling vehicle as the traveling vehicle allocated with the conveyance command has been changed, a second traveling vehicle out of the traveling vehicles not conveying an article as the traveling vehicle capable of arriving at a destination included in the conveyance command in a shorter time than the first traveling vehicle does; and reallocating the conveyance command from the first traveling vehicle to the second traveling vehicle.

Upstream and downstream used in the present description mean upstream and downstream in the travel direction of a preset traveling vehicle (the "one direction" described above). In a traveling vehicle system with a layout having a branching part, when the travel route of the traveling vehicle allocated with the conveyance command has been changed, the distance to the destination may become longer, and conveyance efficiency may extremely decrease. In this regard, in a traveling vehicle system of this configuration, at the timing when the travel route of the first traveling vehicle has been changed, the traveling vehicle that is more appropriate to execute the conveyance command is reconsidered, and if a more appropriate traveling vehicle to execute the conveyance command is found, that traveling vehicle can be a substitute and caused to execute the conveyance command. Consequently, conveyance efficiency in the traveling vehicle can be improved.

In the traveling vehicle system according to an aspect of the present invention, the traveling vehicle controller may include a block controller configured to execute block control for blocking entry of the first traveling vehicle into the branching part when travel on one route included in the travel route of the first traveling vehicle is not permitted at the branching part and block avoidance control releasing the block control by causing the first traveling vehicle to travel on another route when the block control is being executed, and the alternative target searching unit may determine that the travel route of the first traveling vehicle has been changed when the block avoidance control has been executed. In this configuration, the traveling vehicle executing the conveyance command can be reconsidered at a timing when the block avoidance control has been executed.

In the traveling vehicle system according to an aspect of the present invention, the traveling vehicle may repeatedly transmit an entry permission request for the one route to the block controller on an upstream side of the branching part, transmit an entry permission request for the other route when not receiving an entry permission order for a certain time from a start of the transmission of the entry permission request, and enter the other route when receiving the entry permission order from the block controller, and the alternative target searching unit may determine that the travel route of the first traveling vehicle has been changed when the block controller has transmitted the entry permission order for the one route. In this configuration, the timing when the travel route of the first traveling vehicle has been changed can be appropriately acquired.

In the traveling vehicle system according to an aspect of the present invention, the alternative target searching unit may periodically search for the second traveling vehicle. In this configuration, the number of opportunities to reconsider the traveling vehicle to execute the conveyance command can be increased.

### Advantageous Effects of Invention

According to an aspect of the present invention, conveyance efficiency in the traveling vehicle can be improved.

### Brief Description of Drawings

FIG. 1 is a block diagram illustrating a configuration of a traveling vehicle system according to an embodiment.
FIG. 2 is a functional block diagram illustrating a functional configuration of the traveling vehicle system of FIG. 1.
FIG. 3 is a diagram for illustrating block control, block avoidance control, and conventional alternative control.
FIG. 4 is a sequence diagram of the block control and the block avoidance control.
FIG. 5 is a diagram for illustrating the block control, the block avoidance control, and alternative control of the present embodiment.

### Description of Embodiments

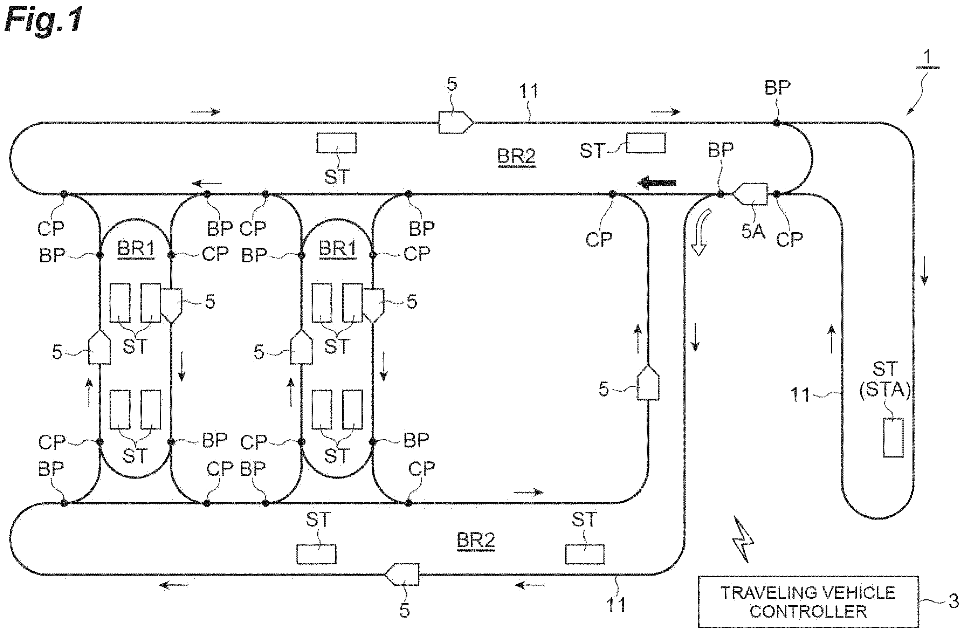

The following describes an embodiment with reference to the accompanying drawings. In the description of the drawings, the same elements are denoted by the same symbols, and redundant descriptions are omitted. The dimensional proportions in the drawings do not necessarily match those in the description. Upstream and downstream when describing the embodiment mean upstream and downstream in the travel direction of a preset ceiling traveling vehicle 5 (hereinafter, simply referred to as a "traveling vehicle 5") (the arrow direction indicated in a track 11 illustrated in FIG. 1: one direction).

A traveling vehicle system 1 is a system for conveying articles using the traveling vehicle 5 that can move along the track (travel path) 11. The traveling vehicle 5 is an unmanned traveling vehicle and is a ceiling traveling vehicle, a tracked bogie, or the like, for example. The following describes the traveling vehicle system 1 in which the traveling vehicle 5 travels along the one-way track 11 laid on the ceiling or the like in a factory or the like as an example. As illustrated in FIG. 1, the traveling vehicle system 1 mainly includes the track 11, a plurality of stations (placement parts) ST, a plurality of traveling vehicles 5, and a traveling vehicle controller 3.

The track 11 is a component causing the traveling vehicle 5 to travel and is suspended from the ceiling. FIG. 1 illustrates an example of the layout of the track 11 in the present embodiment. In the present embodiment, the track 11 has a plurality of compartments (bays). The track 11 includes an intrabay route BR1, which is a travel path within a bay, and an interbay route BR2, which is a travel path connecting different bays to each other. The intrabay route BR1 is set up in such a manner that the traveling vehicle 5 travels one way clockwise. The interbay route BR2, like the intrabay route BR1, is also set up in such a manner that the traveling vehicle 5 travels one way clockwise. The intrabay route BR1 and the interbay route BR2 are provided with branching parts BP for branching the track 11 and merging parts CP for merging the track 11.

The stations ST are provided along the track 11. The stations ST are parts where articles are delivered to and from the traveling vehicle 5. Examples of the stations ST in a semiconductor processing factory include load ports for delivering FOUPs between a semiconductor processing apparatus and the traveling vehicle 5 and buffers where the traveling vehicle 5 can temporarily store FOUPs.

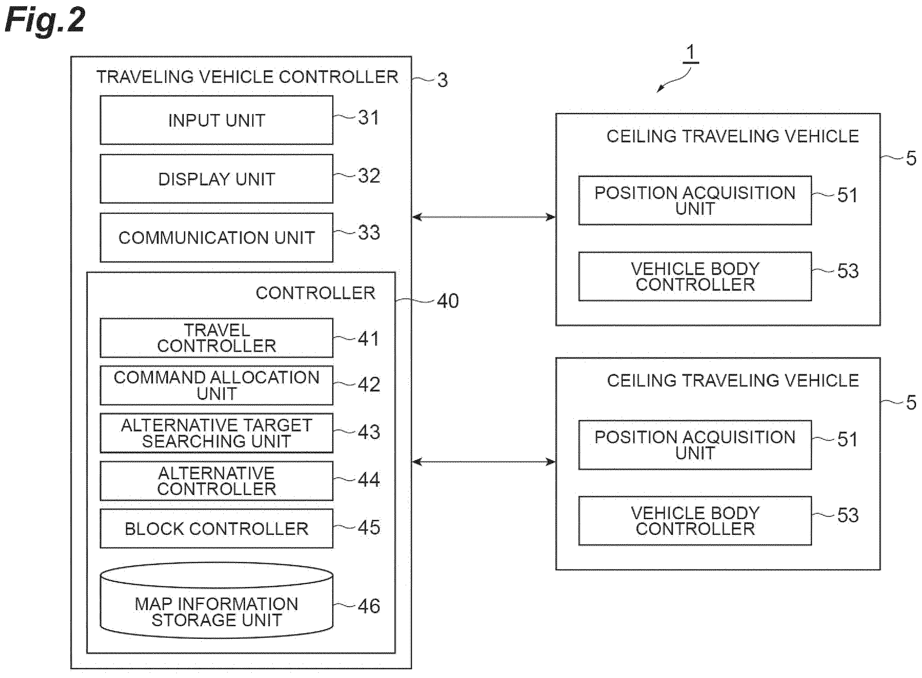

The traveling vehicle 5 can transfer articles. In addition to known mechanisms for transferring articles, the traveling vehicle 5 includes a position acquisition unit 51 and a vehicle body controller 53 as illustrated in FIG. 2.

The position acquisition unit 51 is a part acquiring the position of the traveling vehicle itself on the track 11. The position acquisition unit 51 may include a reader reading a barcode or the like indicating point information affixed to the track 11 and an encoder, for example. The position acquisition unit 51 transmits the point information obtained by the reader and a distance traveled after passing through the point obtained from the encoder to the traveling vehicle controller 3 as position data. By periodically or continuously transmitting the information acquired by the position acquisition unit 51 to the traveling vehicle controller 3, the traveling vehicle controller 3 can determine the position of the traveling vehicle 5.

The vehicle body controller 53 is a part controlling the travel of the traveling vehicle 5 and is an electronic controlling unit including a central processing unit (CPU), a read only memory (ROM), and a random access memory (RAM), for example. The vehicle body controller 53 controls the travel of the traveling vehicle 5 based on a conveyance command transmitted from the traveling vehicle controller. The conveyance command transmitted from a higher-level controller (not illustrated) includes information on a station ST as a destination (hereinafter also referred to as a "target station STA").

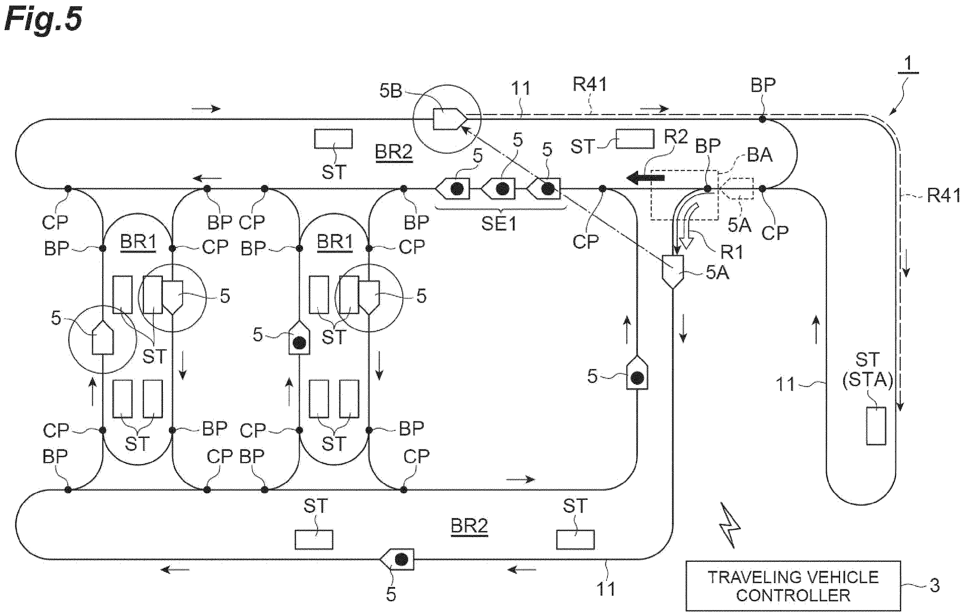

On the upstream side of the branching part BP (the boundary of a blocking area BA) (refer to FIG. 5), the traveling vehicle 5 starts transmitting an entry permission request for one route R1 in response to periodic status inquiries from the traveling vehicle controller 3 and transmits an entry permission request for another route R2 to the traveling vehicle controller 3 when not receiving an entry permission order for a certain time (10 seconds to 30 seconds, for example) starting from the arrival at the boundary of the blocking area BA (or starting from the start of the transmission of the entry permission request). When receiving the entry permission order for the other route R2 from the traveling vehicle controller 3, the traveling vehicle 5 enters the other route R2.

The traveling vehicle controller 3 is a part controlling the traveling vehicle 5. More specifically, the traveling vehicle controller 3 has a travel control function controlling the travel of the traveling vehicle 5 based on the conveyance command transmitted from the higher-level controller (not illustrated). The traveling vehicle controller 3 controls the travel of a plurality of the traveling vehicles 5 and has an allocation function allocating conveyance commands to the traveling vehicles 5. The traveling vehicle controller 3 inquires of each traveling vehicle 5 about the presence or absence of carrying an article at a constant cycle, thereby determining the presence or absence of carrying an article for each traveling vehicle 5.

As illustrated in FIG. 2, the traveling vehicle controller 3 includes an input unit 31, a display unit 32, a communication unit 33, and a controller 40. The input unit 31 includes a keyboard and a mouse or the like, for example, and is a part to which various operations and various setting values are input by a user. The display unit 32 includes a liquid crystal display, for example, and is a part displaying various setting screens and displaying input screens to prompt input through the input unit 31 or the like. The input unit 31 and the display unit 32 are not required to be provided integrally with the traveling vehicle controller 3 and can be replaced by a terminal device enabling communication.

The communication unit 33 is a processing unit performing communication with other devices or the like and transmits the conveyance command to the traveling vehicle 5 or receives information on the current position and the presence or absence of carrying an article of the traveling vehicle 5 via a wireless communication network, for example. The communication unit 33 also receives conveyance instructions including information on the station ST as a destination from the higher-level controller via a local area network (LAN), for example.

The controller 40 is a part executing various control processing in the traveling vehicle system 1, which is described in detail in the following section, and includes a CPU, a ROM, and a RAM, for example. As illustrated in FIG. 2, the controller 40 has a travel controller 41, a command allocation unit 42, an alternative target searching unit 43, an alternative controller 44, a block controller 45, and a map information storage unit 46 as conceptual parts executing the various control processing in the traveling vehicle system 1. The travel controller 41, the command allocation unit 42, the alternative target searching unit 43, the alternative controller 44, and the block controller 45 formed as such conceptual parts can be configured as software in which a computer program stored in the ROM is loaded onto the RAM and executed by the CPU, for example. The map information storage unit 46 includes hardware such as a solid state drive (SSD) or a hard disk drive (HDD). The controller 40 may be configured as hardware including electronic circuits and the like.

Upon occurrence of a conveyance command, the travel controller 41 searches for a travel route causing the traveling vehicle 5 to travel to the target station STA included in the conveyance command based on the map information and causes the traveling vehicle 5 to travel in accordance with the travel route. In the present embodiment, the conveyance command is transmitted from the higher-level controller. The map information described above is information on the track 11 and the stations ST and is stored in the map information storage unit 46. More specifically, the map information is layout information indicating the laying status of the track 11 and the placement status of the stations ST. The laying status of the track 11 is indicated by a plurality of nodes and a plurality of links. The placement status of the stations ST is indicated in association with the nodes or positions (point information) set for the respective nodes. The travel controller 41, having received the conveyance command, moves the traveling vehicle 5 to the target station STA in order to cause the traveling vehicle 5 to receive (pick up) an article at the target station STA included in the conveyance command.

The command allocation unit 42 identifies a traveling vehicle 5 to be caused to execute the conveyance command out of the traveling vehicles 5. In other words, the command allocation unit 42 selects one traveling vehicle 5 that can arrive at the target station STA first (the traveling vehicle 5 with the shortest travel route length to the target station STA, for example) out of the traveling vehicles 5 and causes the selected traveling vehicle 5 to start movement to the target station STA.

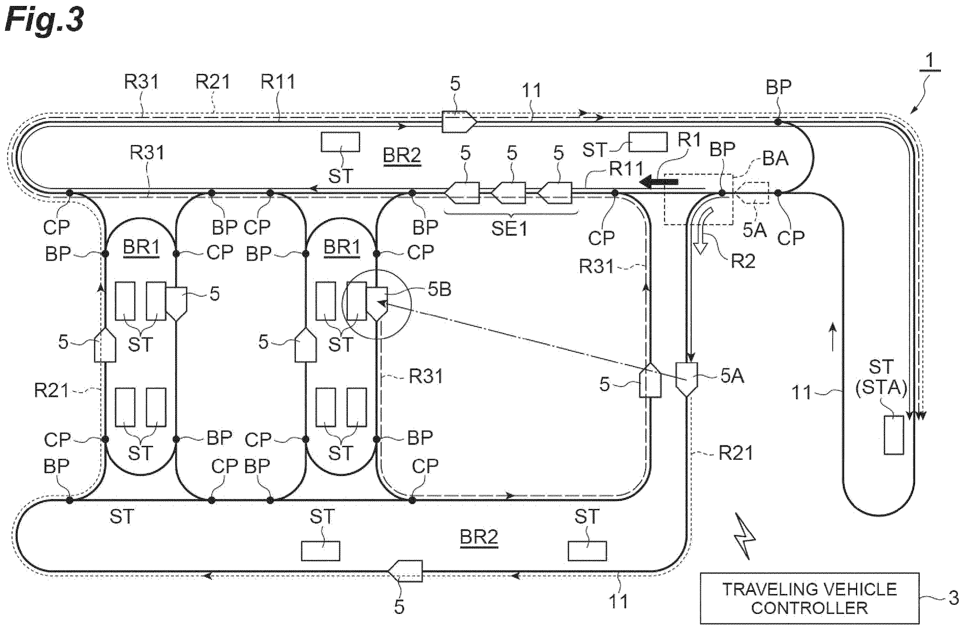

The following describes block control (what is called deadlock control) and block avoidance control (what is called deadlock escape control) using FIG. 3 and FIG. 5. The block control and the block avoidance control are pieces of control performed when the traveling vehicle 5 (5A) allocated (tentatively allocated) with the conveyance command by the command allocation unit 42 passes through the branching part BP as part of a travel route R11 searched for by the travel controller 41.

More specifically, when the first traveling vehicle 5A allocated with the conveyance command arrives at the branching part BP to attempt to enter the one route R1 set as the travel route R11, the entry into the one route R1 may not be permitted. At this time, the control by which the entry into the branching part BP (more specifically, the blocking area BA) is blocked is the block control. Examples of states in which the entry into the one route R1 is not permitted include a state in which the one route R1 or the downstream part thereof is congested (SE1) with traveling vehicles 5 and a state with temporary traffic closure due to maintenance or the like.

The block avoidance control is a control causing the first traveling vehicle 5A to enter the other route R2 and again searches for a travel route R21 for causing the first traveling vehicle 5A to pass through the route R2 and to arrive at the target station STA from the branching part BP when the state in which the entry into the one route R1 is not permitted continues for a certain time by the block control. Control causing the first traveling vehicle 5A to enter the one route R1 when the state in which the entry into the one route R1 is not permitted is dissolved is referred to as block release control, as distinguished from the above block avoidance control.

The following describes alternative control (what is called SWAP control). The alternative control is control reallocating the conveyance command from the first traveling vehicle 5A to a second traveling vehicle 5B, which is another traveling vehicle 5 not conveying any article and is the traveling vehicle 5 that can arrive at the target station STA included in the conveyance command in a shorter time than the first traveling vehicle 5A does. While conventional alternative control determines whether to execute the alternative control at a timing when the traveling vehicle 5 having been vacant has occurred, as described below, the alternative control of the present embodiment is executed at a timing when the travel route R11 of the first traveling vehicle 5A has been changed. More specifically, the alternative control is executed at a timing when it is determined that the travel route R11 of the first traveling vehicle 5A has been changed, when the travel route R21 of the first traveling vehicle 5A and a travel route R31 of the second traveling vehicle 5B are compared to each other, and when the route length of the travel route R31 is shorter than that of the travel route R21 and is not executed when the route lengths of the travel route R31 and the travel route R21 are equal or when the route length of the travel route R21 is shorter than that of the travel route R31.

The following describes various processing units executing the block control, the block avoidance control, and the alternative control. The alternative target searching unit 43 searches out of the traveling vehicles 5 not conveying an article (vacant traveling vehicles) (in FIG. 5, the traveling vehicles 5 conveying an article are indicated by a black circle (•)) and at a timing when the travel route R11 of the first traveling vehicle 5A allocated with the conveyance command has been changed, the second traveling vehicle 5B that can arrive at the target station STA in a shorter time than the first traveling vehicle 5A can. Examples of being able to arrive at the target station STA in a shorter time than the first traveling vehicle 5A include a case in which the route length of the second traveling vehicle 5B searched for by the alternative target searching unit 43 is shorter than the route length of the first traveling vehicle 5A. The alternative target searching unit 43 searches 3 for the second traveling vehicle 5B among all the traveling vehicles 5 managed (controlled) by the traveling vehicle controller.

The alternative target searching unit 43 of the present embodiment determines that the first traveling vehicle 5A has passed through the branching part BP when it is determined that the block avoidance control has been executed by the block controller 45, which is described in detail in the following section. More specifically, the alternative target searching unit 43 determines that the first traveling vehicle 5A has passed through the branching part BP when the block controller 45 has transmitted the entry permission order for the other route R2.

The alternative controller 44 executes the alternative control reallocating the conveyance command from the first traveling vehicle 5A to the second traveling vehicle 5B when the second traveling vehicle 5B has been identified by the alternative target searching unit 43. The second traveling vehicle 5B, having been allocated with the conveyance command by the alternative controller 44, is controlled by the travel controller 41 to be moved to the target station STA.

The block controller 45 executes the block control blocking entry into the branching part BP when the entry into the one route R1 included in the travel route R11 of the first traveling vehicle 5A is not permitted at the branching part BP, the block avoidance control avoiding block by causing the first traveling vehicle 5A to travel on the other route R2, and the block release control releasing the control blocking the entry into the branching part BP when the state in which the entry into the one route R1 included in the travel route R11 of the first traveling vehicle 5A is not permitted has been released. The block controller 45 transmits the entry permission order or an entry prohibition order in response to the entry permission request for the one route R1 transmitted from the traveling vehicle 5. The block controller 45 also transmits the entry permission order or the entry prohibition order in response to the entry permission request for the other route R2 transmitted from the traveling vehicle 5.

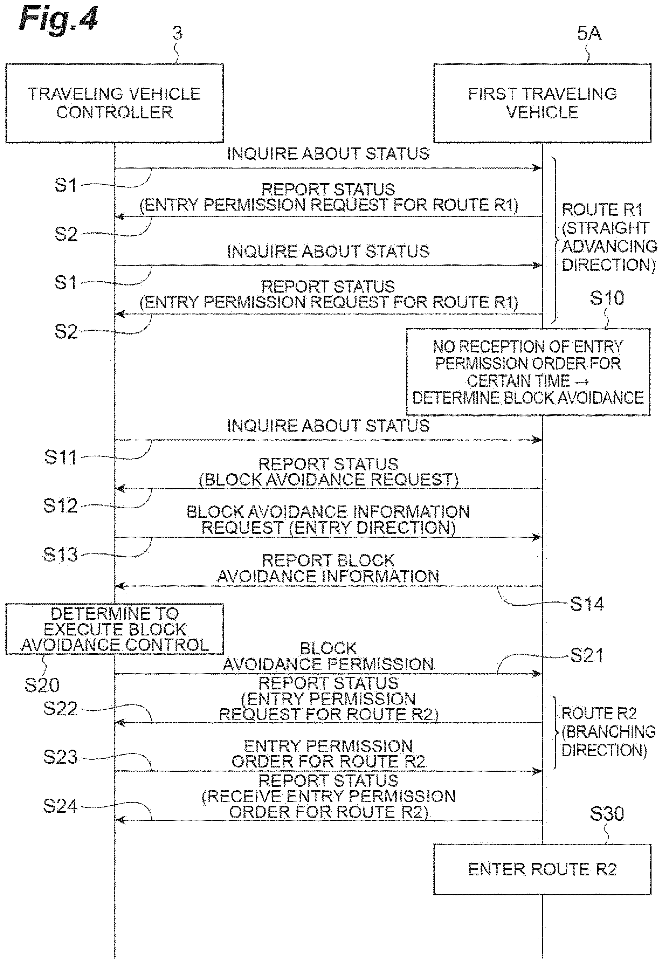

The following describes a procedure until the traveling vehicle controller 3 (the alternative target searching unit 43) determines that the first traveling vehicle 5A has passed through the branching part BP with reference to FIG. 4.

The first traveling vehicle 5A, having received the conveyance command, cannot pass through the branching part BP unless it receives a passing permission order from the traveling vehicle controller 3 at a permission waiting point at the boundary of the blocking area BA. The traveling vehicle controller 3 repeatedly inquires with the first traveling vehicle 5A waiting for permission about the status (Step S1). This status inquiry may be repeated periodically or repeated irregularly. Upon reception of the status inquiry, the first traveling vehicle 5A transmits the entry permission request for the one route R1 included in the travel route R11 (refer to FIG. 3) to the traveling vehicle controller 3 (Step S2).

The traveling vehicle controller 3, having received the entry permission request for the one route R1 from the first traveling vehicle 5A, does not respond when it cannot permit the entry into the one route R1 and transmits the entry permission order for the one route R1 to the first traveling vehicle 5A when it can permit the entry into the one route R1. When not being able to permit the entry into the one route R1, the traveling vehicle controller 3 may transmit the entry prohibition order for the one route R1 to the first traveling vehicle 5A. While such Steps S1 and S2 are repeated at a constant cycle, when a time during which the first traveling vehicle 5A cannot receive the entry permission order continues for a certain time after arriving at the permission waiting point, entry into the other route R2 is determined (Step S10).

Upon the above inquiry being made (Step S11), the first traveling vehicle 5A transmits a block avoidance request (Step S12). The traveling vehicle controller 3, having received the block avoidance request, transmits a block avoidance information request (that is, an order inquiring about which route it wishes to enter) to the first traveling vehicle 5A (Step S13). The traveling vehicle 5, having received the inquiry order, transmits block avoidance information, which is information on the route it wishes to enter, to the traveling vehicle controller 3 (Step S14). The traveling vehicle controller 3, having received the block avoidance information, determines to execute the block avoidance control described above (Step S20).

The traveling vehicle controller 3, having determined to execute the block avoidance control, reports block avoidance permission to the first traveling vehicle 5A (Step S21). The traveling vehicle controller 3, having received the report of block avoidance permission, transmits the entry permission request for the other route R2 (Step S22). The traveling vehicle controller 3, having received the entry permission request for the other route R2, transmits the entry permission order for the other route R2 (Step S23). The traveling vehicle controller 3 (the alternative target searching unit 43) determines that the travel route of the first traveling vehicle 5A has been changed at a point in time when the entry permission order for the other route R2 has been transmitted. The first traveling vehicle 5A, having received the entry permission order for the other route R2, transmits information about having received the entry permission order for the other route R2 to the traveling vehicle controller 3 (Step S24) and also enters the other route R2 (Step S30).

The following describes the effects of the traveling vehicle system 1 and the method for controlling the traveling vehicle 5 of the above embodiment. In the traveling vehicle system 1 with a layout having the branching part BP as illustrated in FIG. 3, when the travel route R11 of the traveling vehicle 5 allocated with the conveyance command has been changed to the travel route R21, for example, the distance to the target station STA becomes longer, and conveyance efficiency may extremely decrease. In this regard, in the traveling vehicle system 1 of the present embodiment, at the timing when the travel route R11 of the first traveling vehicle 5 has been changed, the traveling vehicle 5 that is more appropriate to execute the conveyance command is reconsidered, and when the second traveling vehicle 5B (refer to FIG. 5) that is more appropriate to execute the conveyance command is identified, the conveyance command is reallocated from the first traveling vehicle 5A to the second traveling vehicle 5B. Consequently, conveyance efficiency in the traveling vehicle 5 can be improved.

In the conventional alternative control described above, it is determined whether the alternative control is executed at a timing when the second traveling vehicle 5B having been vacant has occurred. In this case, the traveling vehicle 5 at the circled position in FIG. 3 becomes the second traveling vehicle 5B, for example, and even if the alternative control is executed here, the route length of the travel route R31 to the target station STA is not much different from that of the travel route R21. In this regard, the alternative control of the present embodiment is executed at the timing when the travel route R11 of the first traveling vehicle 5A has been changed to the travel route R21, and all the traveling vehicles 5 managed by the traveling vehicle controller 3 are searched, and thus the optimal traveling vehicle 5 is selected out of the traveling vehicles 5 not conveying an article (the traveling vehicles 5 circled in FIG. 5). With this selection, a more optimal traveling vehicle 5 substitutes.

The traveling vehicle system 1 of the above embodiment determines that the travel route R11 of the first traveling vehicle 5A has been changed when the block avoidance control has been executed. With this determination, the traveling vehicle 5 executing the conveyance command can be reconsidered at a timing when the traveling vehicle 5 travels on the other route R2, which is different from the original route of the first traveling vehicle 5A.

The traveling vehicle system 1 of the above embodiment determines that the travel route of the first traveling vehicle 5A has been changed when the traveling vehicle controller 3 has transmitted the entry permission order for the other route R2. With this determination, the timing at which the travel route of the first traveling vehicle 5A has been changed can be appropriately acquired.

Although one embodiment has been described, the present invention is not limited to the above embodiment. Various changes can be made without departing from the gist of the invention.

In the traveling vehicle controller 3 of the above embodiment, the second traveling vehicle 5B is searched for only at the timing when the travel route R11 of the first traveling vehicle 5A has been changed, but in addition to such control, the second traveling vehicle 5B (that is, the traveling vehicle 5 that can arrive at the target station STA included in the conveyance command in a shorter time than the first traveling vehicle 5A does out of the traveling vehicles 5 not conveying an article) may be searched for periodically. In this configuration, the number of opportunities to reconsider the traveling vehicle 5 executing the conveyance command can be increased.

In the traveling vehicle controller 3 of the above embodiment, an example in which all the traveling vehicles 5 on the track 11 managed by the traveling vehicle controller 3 are targeted has been described, but for example, a traveling vehicle 5 the distance of which from the target station STA is a certain distance or more may be excluded from the search.

In the above embodiment, the configuration of the track 11 including the two intrabay routes BR1 and BR1 and the interbay route BR2 connecting different bays to each other has been described as an example, but any layout may be used so long as it has a configuration of the track 11 including the merging parts CP and the branching parts BP.

In the above embodiment, an example in which the higher-level controller and the traveling vehicle controller 3 are configured as separate units has been described, but they may be configured as a single unit.

In the traveling vehicle system 1 of the above embodiment and modification, the ceiling traveling vehicle 5 has been described as an example of the traveling vehicle, but other examples of the traveling vehicle include unmanned traveling vehicles traveling on tracks laid on the ground or on platforms.

### Reference Signs List

- 1: Traveling vehicle system
- 3: Traveling vehicle controller
- 5: Traveling vehicle
- 5A: First traveling vehicle
- 5B: Second traveling vehicle
- 11: Track (travel path)
- 40: Controller
- 41: Travel controller
- 42: Command allocation unit
- 43: Alternative target searching unit
- 44: Alternative controller
- 45: Block controller
- BA: Blocking area
- BP: Branching part
- R1: One route
- R2: Another route
- ST: Station (placement part)
- STA: Target station

## Claims

1. A traveling vehicle system comprising:
a travel path including a branching part and on which a traveling vehicle travels in one direction;
a plurality of traveling vehicles configured to travel along the travel path and to deliver an article to and from a placement part provided along the travel path; and
a traveling vehicle controller configured to cause the traveling vehicles to travel in accordance with a travel route searched for based on a conveyance command for conveying the article,
the traveling vehicle controller includes:
an alternative target searching unit configured to search, at a timing when the travel route of a first traveling vehicle as the traveling vehicle allocated with the conveyance command has been changed, a second traveling vehicle out of the traveling vehicles not conveying an article as the traveling vehicle capable of arriving at a destination included in the conveyance command in a shorter time than the first traveling vehicle does; and
an alternative controller configured to reallocate the conveyance command from the first traveling vehicle to the second traveling vehicle when the second traveling vehicle has been identified by the alternative target searching unit.

2. The traveling vehicle system according to claim 1, wherein
the traveling vehicle controller includes a block controller configured to execute block control for blocking entry of the first traveling vehicle into the branching part when travel on one route included in the travel route of the first traveling vehicle is not permitted at the branching part and block avoidance control releasing the block control by causing the first traveling vehicle to travel on another route when the block control is being executed, and
the alternative target searching unit determines that the travel route of the first traveling vehicle has been changed when the block avoidance control has been executed.

3. The traveling vehicle system according to claim 2, wherein
the traveling vehicle repeatedly transmits an entry permission request for the one route to the block controller on an upstream side of the branching part, transmits an entry permission request for the other route when not receiving an entry permission order for a certain time from a start of the transmission of the entry permission request, and enters the other route when receiving the entry permission order from the block controller, and
the alternative target searching unit determines that the travel route of the first traveling vehicle has been changed when the block controller has transmitted the entry permission order for the one route.

4. The traveling vehicle system according to any one of claims 1 to 3, wherein the alternative target searching unit periodically searches for the second traveling vehicle.

5. A method for controlling a traveling vehicle in a traveling vehicle system including: a travel path including a branching part and on which a traveling vehicle travels in one direction; a plurality of traveling vehicles configured to travel along the travel path and to deliver an article to and from a placement part provided along the travel path; and a traveling vehicle controller configured to cause the traveling vehicles to travel based on a travel route searched for based on a conveyance command for conveying the article, the method comprising:
identifying, at a timing when the travel route of a first traveling vehicle as the traveling vehicle allocated with the conveyance command has been changed, a second traveling vehicle out of the traveling vehicles not conveying an article as the traveling vehicle capable of arriving at a destination included in the conveyance command in a shorter time than the first traveling vehicle does; and
reallocating the conveyance command from the first traveling vehicle to the second traveling vehicle.
